# EUROPEAN PATENT APPLICATION

(11) **EP 4 832 709 A1**
(43) Date of publication of application: **28.10.2026**
(21) Application number: 26166693.7
(22) Date of filing: 23.03.2026
(51) Int. Cl.: H10K 30/35, H10K 30/00, H10K 30/50

(54) **PHOTOELECTRIC CONVERSION DEVICE, AND METHOD FOR MANUFACTURING PHOTOELECTRIC CONVERSION DEVICE**

(30) Priority: 21.04.2025 JP 2025069779
(71) Applicant: Toyota Jidosha Kabushiki Kaisha, Toyota-shi, Aichi-ken 471-8571 (JP)
(72) Inventor: MATSUNOBU, Kohei, Toyota-shi, 471-8571 (JP); MABUCHI, Takashi, Toyota-shi, 471-8571 (JP); OKUMURA, Kenichi, Toyota-shi, 471-8571 (JP)
(74) Representative: Kuhnen & Wacker Patent- und Rechtsanwaltsbüro PartG mbB

(57) **Abstract**

An object of the present disclosure is to provide a photoelectric conversion device, a method for manufacturing a photoelectric conversion device, a tandem solar cell, and a window glass capable of improving photoelectron conversion efficiency. A photoelectric conversion device (1) according to the present disclosure includes: a first electrode layer (12), which is a transparent electrode; a second electrode layer (16); and a photoactive zone (141) that is positioned between the first electrode layer (12) and the second electrode layer (16). The photoelectric conversion device (1) according to the present disclosure further includes a reflection suppression zone (142) including string-like nanoparticles between the photoactive zone (141) and the first electrode layer (12).

## Description

### BACKGROUND

The present disclosure relates to a photoelectric conversion device, a method for manufacturing a photoelectric conversion device, a tandem solar cell, and a window glass.

Patent Literature 1 discloses a perovskite solar cell including a transparent conductive support, an electron blocking layer, a perovskite layer, an electron transport layer, a hole blocking layer, and a back electrode, in which the electron blocking layer and the hole blocking layer both include inorganic materials.

[Patent Literature 1] International Patent Publication No. WO 2017/073472

### SUMMARY

Incidentally, there is a problem, in the solar cell according to related art, that an amount of solar light that is made incident into the photoactive layer decreases as a result of the solar light reflecting on the interface of the photoactive layer, as a result of which photoelectron conversion efficiency is reduced.

That is, there is a problem, in the solar cell and a photoelectric conversion device used for the solar cell according to related art, that photoelectron conversion efficiency cannot be sufficiently improved. Patent Literature 1 does not disclose any technique capable of solving the aforementioned problem.

The present disclosure has been made in order to solve the aforementioned problem, and an object of the present disclosure is to provide a photoelectric conversion device, a method for manufacturing a photoelectric conversion device, a tandem solar cell, and a window glass capable of improving photoelectron conversion efficiency.

A photoelectric conversion device according to the present disclosure includes a first electrode layer, which is a transparent electrode, a second electrode layer, and a photoactive zone that is positioned between the first electrode layer and the second electrode layer. The photoelectric conversion device according to the present disclosure includes a reflection suppression zone including string-like nanoparticles between the photoactive zone and the first electrode layer.

With the aforementioned configuration, due to the presence of the string-like nanoparticles included in the reflection suppression zone, the light that is made incident on the photoelectric conversion device scatters and reflection of the incident light is suppressed. As a result, the photoelectric conversion device according to the present disclosure can improve the photoelectron conversion efficiency.

The photoelectric conversion device according to the present disclosure may further include a carrier transport layer provided between the first electrode layer and the photoactive zone. Then the reflection suppression zone may be positioned between the photoactive zone and the carrier transport layer.

In the photoelectric conversion device according to the present disclosure, the string-like nanoparticles may include silicon dioxide as a main component.

In the photoelectric conversion device according to the present disclosure, a thickness of the reflection suppression zone is preferably 37 nm or more but 64 nm or less.

In the photoelectric conversion device according to the present disclosure, a thickness of the reflection suppression zone is preferably 0.10 times or less of a total of a thickness of the photoactive zone and a thickness of the reflection suppression zone.

In the photoelectric conversion device according to the present disclosure, the thickness of the reflection suppression zone is preferably 0.05 times or more but 0.10 times or less of a total of the thickness of the photoactive zone and the thickness of the reflection suppression zone.

In the photoelectric conversion device according to the present disclosure, a length of the string-like nanoparticles in a longitudinal direction is preferably 40 nm or more but 100 nm or less.

In the photoelectric conversion device according to the present disclosure, a length of the string-like nanoparticles in a radial direction is preferably 13 nm or more.

In the photoelectric conversion device according to the present disclosure, the photoactive zone may include a perovskite compound as a main component.

The photoelectric conversion device according to the present disclosure may include a region where the photoactive zone and the carrier transport layer contact each other without the string-like nanoparticles interposed therebetween.

A method for manufacturing a photoelectric conversion device according to the present disclosure is a method for manufacturing a photoelectric conversion device including a first electrode layer, which is a transparent electrode, a second electrode layer, and a photoactive zone that is positioned between the first electrode layer and the second electrode layer. The method for manufacturing the photoelectric conversion device according to the present disclosure includes: preparing a substrate that includes a first electrode layer; forming a reflection suppression zone including string-like nanoparticles; and forming a photoactive zone.

The method for manufacturing the photoelectric conversion device according to the present disclosure may further include forming a carrier transport layer on the first electrode layer. Then forming the reflection suppression zone may include: applying a nanoparticle dispersion solution onto the carrier transport layer; and volatilizing a solvent of the nanoparticle dispersion solution. Further, forming the photoactive zone may include: applying the precursor solution of a photoactive zone onto the reflection suppression zone; and volatilizing the solvent of the precursor solution of the photoactive zone.

In the method for manufacturing the photoelectric conversion device according to the present disclosure, a concentration of inorganic nanoparticles of the nanoparticle dispersion solution is preferably 3.0 wt% or less.

In the method for manufacturing the photoelectric conversion device according to the present disclosure, a concentration of the inorganic nanoparticles of the nanoparticle dispersion solution is preferably 0.5% or more but 2.5 wt% or less.

In the method for manufacturing the photoelectric conversion device according to the present disclosure, a concentration of the inorganic nanoparticles of the nanoparticle dispersion solution is preferably 1.0% or more but 2.0 wt% or less.

A tandem solar cell according to the present disclosure is a tandem solar cell including a plurality of photoelectric conversion devices. In the tandem solar cell according to the present disclosure, one of the plurality of photoelectric conversion devices that is located on an outermost surface as viewed from a light-incident side includes a first electrode layer, which is a transparent electrode, a second electrode layer, and a photoactive zone that is positioned between the first electrode layer and the second electrode layer. Then, the photoelectric conversion device located on the outermost surface as viewed from the light-incident side further includes a reflection suppression zone including string-like nanoparticles between the photoactive zone and the first electrode layer.

A window glass according to the present disclosure is a window glass including a photoelectric conversion device. In the window glass according to the present disclosure, the photoelectric conversion device includes a first electrode layer, which is a transparent electrode, a second electrode layer, and a photoactive zone that is positioned between the first electrode layer and the second electrode layer. Then the photoelectric conversion device further includes a reflection suppression zone including string-like nanoparticles between the photoactive zone and the first electrode layer.

According to the present disclosure, it is possible to provide a photoelectric conversion device, a method for manufacturing a photoelectric conversion device, a tandem solar cell, and a window glass capable of improving photoelectron conversion efficiency.

The above and other objects, features and advantages of the present disclosure will become more fully understood from the detailed description given hereinbelow and the accompanying drawings.

### BRIEF DESCRIPTION OF DRAWINGS

Fig. 1 is a cross-sectional view showing a configuration of a photoelectric conversion device according to a first embodiment;
Fig. 2 is a bird's eye view showing a shape of string-like nanoparticles according to the first embodiment;
Fig. 3 is a photograph showing a configuration of string-like nanoparticles according to the first embodiment;
Fig. 4 is a flowchart showing a method for manufacturing the photoelectric conversion device according to the first embodiment;
Fig. 5 is a cross-sectional view for describing the method for manufacturing the photoelectric conversion device according to the first embodiment;
Fig. 6 is a cross-sectional view for describing the method for manufacturing the photoelectric conversion device according to the first embodiment;
Fig. 7 is a flowchart showing a configuration of the photoelectric conversion device according to the first embodiment;
Fig. 8 is a cross-sectional view for describing a method for manufacturing the photoelectric conversion device according to the first embodiment;
Fig. 9 is a cross-sectional view for describing the method for manufacturing the photoelectric conversion device according to the first embodiment;
Fig. 10 is a cross-sectional view for describing the method for manufacturing the photoelectric conversion device according to the first embodiment; and
Fig. 11 is a graph showing results of estimating a short-circuit current density lost as a result of light reflection.

### DESCRIPTION OF EMBODIMENTS

### <First Embodiment>

### (Configuration of Photoelectric conversion device)

Hereinafter, with reference to the drawings, a first embodiment according to the present disclosure will be described in detail. First, a configuration of a photoelectric conversion device according to this embodiment will be described in detail.

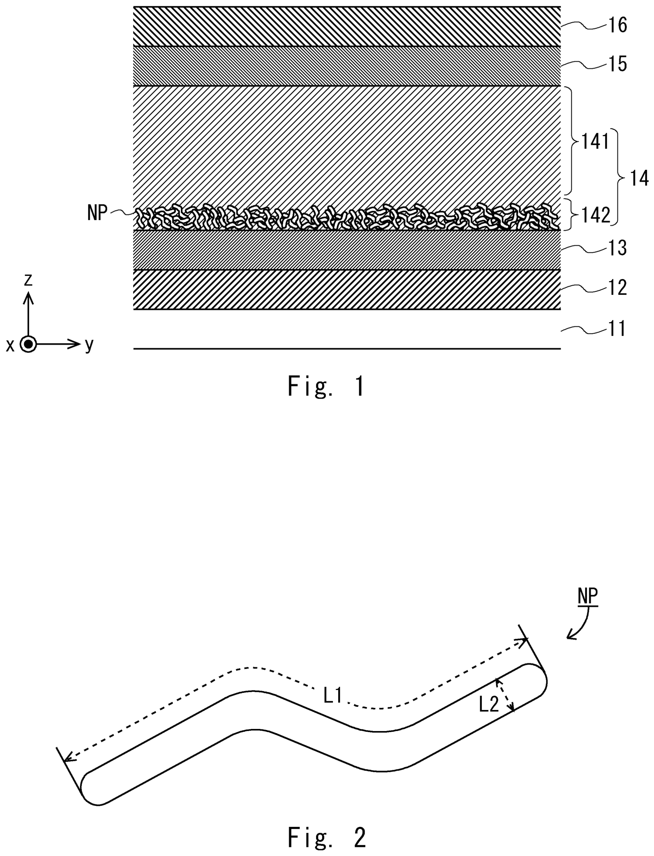

Fig. 1 is a cross-sectional view showing a configuration of the photoelectric conversion device according to the first embodiment. More specifically, Fig. 1 is a schematic cross-sectional view when the photoelectric conversion device according to the first embodiment is cut on a plane perpendicular to the main surface. As a matter of course, the right-handed xyz orthogonal coordinates shown in Fig. 1 and other drawings are for the sake of convenience in explaining the position relationship of the components, which are common throughout the drawings.

Further, the z-axis positive side may be herein expressed as an upper side and the z-axis negative side may be herein expressed as a lower side for the sake of convenience.

A photoelectric conversion device 1 according to this embodiment is an element that converts light incident from the z-axis positive side or the z-axis negative side into electric power. The photoelectric conversion device 1 is typically used as a solar cell. As shown in Fig. 1, the photoelectric conversion device 1 includes a substrate 11, a first electrode layer 12, a first carrier transport layer 13, a photoactive layer 14, a second carrier transport layer 15, and a second electrode layer 16.

Note that the photoelectric conversion device 1 according to this embodiment may be used as an upper cell of a tandem solar cell.

While the details will be described later, the photoelectric conversion device 1 according to this embodiment can suppress reflection of incident light. Therefore, the photoelectric conversion device 1 according to this embodiment is used as one of a plurality of photoelectric conversion devices that is located on the outermost surface as viewed from the light-incident side in the tandem solar cell, whereby the amount of power generated in the photoelectric conversion device which is located in the deeper part as viewed from the light-incident side can be improved as well.

That is, the photoelectric conversion device 1 according to this embodiment provides special effects as it is used as the upper cell of the tandem solar cell.

Further, the photoelectric conversion device 1 according to this embodiment may be used, for example, for solar cells provided in a window glass of a vehicle or a building.

As described above, the photoelectric conversion device 1 according to this embodiment can suppress reflection of incident light. Therefore, the photoelectric conversion device 1 according to this embodiment allows more light to enter the interior of the vehicle or the building as it is used for the solar cells provided in the window glass of the vehicle or the building.

That is, the photoelectric conversion device 1 according to this embodiment provides special effects as it is applied to the solar cells provided in the window glass.

### (Configuration of Substrate 11)

The substrate 11, which is a plate-like or film-like member, is in contact with the first electrode layer 12 on the main surface on the z-axis positive side of the substrate 11.

The substrate 11 may be made of any material as long as the material transmits at least light having a wavelength band absorbed by the photoelectric conversion device 1. Specific examples of the material of the substrate 11 may include, for example, glass, resin, or the like.

From the viewpoint of manufacturing efficiency, the substrate 11 is preferably a film-like member made of a resin material. From the viewpoint of durability, the substrate 11 is preferably a plate-like member made of a glass material. The configuration of the substrate 11 can be selected as appropriate depending on the purpose and the like of using the photoelectric conversion device 1.

### (Configuration of First Electrode Layer 12)

The first electrode layer 12 is a layer having conductivity and light transmission properties. That is, the first electrode layer 12 is implemented as a transparent electrode layer.

The first electrode layer 12 is in contact with the substrate 11 on the main surface on the z-axis negative side of the first electrode layer 12, and is in contact with the first carrier transport layer 13 on the main surface on the z-axis positive side of the first electrode layer 12. That is, the first electrode layer 12 according to this embodiment is positioned between the substrate 11 and the first carrier transport layer 13.

The first electrode layer 12 receives carriers generated in the photoactive layer 14 via the first carrier transport layer and outputs the received carries to the outside. The carriers here means holes or conduction electrons.

When the first carrier transport layer 13 that will be described later is a hole transport layer, the first electrode layer 12 receives the holes generated in the photoactive layer 14 as carriers and output the received holes to the outside.

Further, when the first carrier transport layer 13 is an electron transport layer, the first electrode layer 12 receives the conduction electrons generated in the photoactive layer 14 as carriers, and outputs the received conduction electrons to the outside.

The material of the first electrode layer 12 may include, for example, Indium Tin Oxide (ITO), Indium Zinc Oxide (IZO), impurity-doped Zinc Oxide (ZnO), F-doped Tin Oxide (FTO), Antimony-doped Tin Oxide (ATO), graphene, and metal nanowires.

### (Configurations of First Carrier Transport Layer 13 and Second Carrier Transport Layer 15)

In the photoelectric conversion device 1 according to this embodiment, the first carrier transport layer 13 is a hole transport layer (HTL) and the second carrier transport layer 15 is an electron transport layer (ETL). That is, the photoelectric conversion device 1 according to this embodiment is an inverted structure.

However, the photoelectric conversion device according to the present disclosure may have a regular structure. That is, the photoelectric conversion device according to the present disclosure may include an electron transport layer (ETL) as the first carrier transport layer and a hole transport layer (HTL) as the second carrier transport layer.

### (Configuration of First Carrier Transport Layer 13)

As described above, the first carrier transport layer 13 according to this embodiment is a hole transport layer (HTL). The first carrier transport layer 13 is in contact with the first electrode layer 12 on the main surface on the z-axis negative side of the first carrier transport layer 13, and is in contact with the photoactive layer 14 on the main surface on the z-axis positive side of the first carrier transport layer 13. That is, the first carrier transport layer 13 according to this embodiment is positioned between the first electrode layer 12 and the photoactive layer 14.

The first carrier transport layer 13 transports holes generated in the photoactive layer 14 to the first electrode layer 12. In other words, the holes generated in the photoactive layer 14 move to the first electrode layer 12 via the first carrier transport layer 13.

As the material of the first carrier transport layer 13, both an inorganic hole transport material and an organic hole transport material can be used.

Examples of the inorganic hole transport material may include, for example, CuI, CuInSe₂, CuS, CuSCN, GaP, NiO, FeO, Bi₂O₃, MoO₃, and Cr₂O.

Examples of the organic hole transport material may include, for example, polythiophene derivatives, fluorene derivatives, carbazole derivatives, triphenylamine derivatives, diphenylamine derivatives, polysilane derivatives, and polyaniline derivatives.

Specific examples of the polythiophene derivatives include poly-3-hexylthiophene (P3HT) and polyethylene dioxythiophene (PEDOT). Specific examples of the fluorene derivatives include 2,2',7,7'-tetrakis-(N,N-di-p-methoxyphenylamino)-9,9'-spirobifluorene (Spiro-OMeTAD). Specific examples of the carbazole derivatives include polyvinylcarbazole. Specific examples of the triphenylamine derivatives include poly[bis(4-phenyl)(2,4,6-trimethylphenyl)amine] (PTAA).

Note that the first carrier transport layer 13 according to this embodiment may be formed as a monomolecular film. In this case, the first carrier transport layer 13 may be a monomolecular film that is formed as a result of the compound expressed by the following Formula (1) bonding with the first electrode layer 12.

Ar-(L-Z)ₙ ··· Formula (1)

where
Ar is an n-valent aryl group that may include a heteroaromatic ring,
L is a single bond or a divalent functional group,
Z is a monovalent functional group having bonding properties,
n is a natural number, and
when n is 2 or greater, each (L-Z) may be different from each other.

Ar is an n-valent aryl group that may include a heteroaromatic ring, and preferably includes a nitrogen atom in the heteroaromatic ring from the viewpoint of improving the hole transport properties. When Ar includes a heteroaromatic ring, Ar may have carbon atoms having a bonding hand, hetero atoms having a bonding hand, or both of them. Specific examples of Ar may include, for example, a carbazole ring and a triazatruxene ring.

L is a single bond or a divalent functional group. Note that, when L is a single bond, the compound represented by the chemical formula (1) has a structure where Ar and Z are directly bonded. Specific examples of L may include, for example, divalent alkylene groups such as a 1,1-methylene group or a 1,2-ethylene group, or divalent alkoxy groups such as a diethoxyethylene group.

Z is a monovalent functional group having bonding properties, and is a functional group capable of bonding to the transparent electrode layer and transferring charges to and from the transparent electrode layer. Specific examples of Z may include, for example, a phosphonic acid group, a carboxy group, a sulfo group, a boronic acid group, a trihalogenated silyl group, and a trialkoxysilyl group.

n is a natural number, and is preferably a natural number from 1 to 4. When n is 2 or greater, a plurality of (L-Z) may be the same or may be different from each other.

Specific examples of the compound represented by the above Formula (1) may include, for example, 3PATAT-C3 (Phosphonic acid functionalized triazatruxene).

### (Configuration of Photoactive layer 14)

The photoactive layer 14 excites electrons by absorbing solar light that is incident from the z-axis negative side to generate holes and conduction electrons.

The holes generated in the photoactive layer 14 are transported to the first electrode layer 12 via the first carrier transport layer 13, and the conduction electrons generated in the photoactive layer 14 are transported to the second electrode layer 16 via the second carrier transport layer 15.

The photoactive layer 14 according to this embodiment may include a perovskite compound as a main component, and may contain additives or the like as appropriate. Note that the perovskite compound here indicates a compound group having a perovskite-type crystal structure.

The compound that can be used as the main component of the photoactive layer 14 may include, for example, a perovskite compound expressed by a composition formula shown in the following Formula (2).

AMX₃··· Formula (2)

where
A is a monovalent cation,
M is a divalent cation, and
X is a monovalent anion.

Specific examples of A may include, for example, alkylamine compound ions such as methylammonium (MA) cation, ethylammonium cation, and formamidinium (FA) cation, or alkali-metal ions such as potassium cation, cesium cation, and rubidium cation.

Note that the perovskite compound according to this embodiment may include a plurality of chemical species as A. From the viewpoint of photoelectron conversion efficiency and durability, the perovskite compound preferably includes cesium cation, methylammonium cation, and formamidinium cation.

Specific examples of M may include, for example, a divalent metal ion such as lead, tin, antimony, indium, copper, bismuth, or germanium.

Note that the perovskite compound according to this embodiment may include a plurality of chemical species as M. From the viewpoint of photoelectron conversion efficiency and durability, the perovskite compound preferably includes at least one of lead cation and tin cation.

Specific examples of X may include, for example, halide ions such as fluorine, chlorine, bromine, and iodine.

Note that the perovskite compound according to this embodiment may include a plurality of chemical species as X. From the viewpoint of photoelectron conversion efficiency and durability, the perovskite compound preferably includes at least one of bromine and iodine.

The chemical species and its compositions used as A, M, and X can be adjusted as appropriate in accordance with the performance requested for the photoelectric conversion device. In other words, the photoelectric conversion device 1 according to this embodiment can adjust, for example, performance such as durability and absorption wavelength by adjusting the chemical species and its compositions that are used as A, M, and X.

Note that the main component of the photoactive layer according to the present disclosure is not limited to the perovskite compound. For example, the main component of the photoactive layer according to the present disclosure may be silicon or may be copper oxide. That is, the photoactive layer according to the present disclosure may be made of any material as long as the material is a photoelectric conversion material, which is a material that can absorb the incident light and generate carriers.

However, as will be described later, string-like nanoparticles NP are distributed in the photoactive layer according to the present disclosure. Therefore, the photoactive layer according to the present disclosure is preferably made of a material capable of forming the photoactive layer by a solution method from the viewpoint of simplifying manufacturing. That is, the photoelectric conversion device according to the present disclosure achieves special effects that it is possible to simplify the manufacturing process when the material of the photoactive layer is a material of a perovskite compound or the like.

As shown in Fig. 1, the photoactive layer 14 according to this embodiment includes a photoactive zone 141 and a reflection suppression zone 142. The photoactive zone 141 here indicates a region in the photoactive layer 14 according to this embodiment where the string-like nanoparticles NP are not distributed, and the reflection suppression zone 142 indicates a region in the photoactive layer 14 according to this embodiment where the string-like nanoparticles NP are distributed.

The photoactive zone 141 is a dense layer made of photoelectric conversion materials, and is, in this embodiment, a dense layer made of perovskite compounds. As described above, the photoactive zone 141 is a region where there are no string-like nanoparticles NP.

The photoactive zone 141 is in contact with the second carrier transport layer 15 on the main surface on the z-axis positive side of the photoactive zone 141, and is in contact with the first carrier transport layer 13 on the main surface on the z-axis negative side of the photoactive zone 141 via the reflection suppression zone 142. The photoactive zone 141 generates carriers by absorbing the incident light.

Note that the expression "there are no string-like nanoparticles NP" herein do not necessarily mean that there are no string-like nanoparticles NP in a strict sense. That is, the expression "there are no string-like nanoparticles NP included" also includes a case in which a small amount of string-like nanoparticles NP are unexpectedly mixed into the photoactive zone 141 in a manufacturing process or the like.

From the viewpoint of improving carrier transport efficiency, the photoactive zone 141 and the first carrier transport layer 13 are preferably not strictly isolated from each other by the string-like nanoparticles NP. In other words, it is preferable that there is a region where the photoactive zone 141 and the first carrier transport layer 13 contact each other without the string-like nanoparticles NP interposed therebetween on the boundary between the photoactive layer 14 and the first carrier transport layer 13.

As shown in Fig. 1, in this embodiment, the photoactive zone 141 and the first carrier transport layer 13 are spatially and electrically connected via a dense part made of photoelectric conversion materials distributed so as to fill the gaps between string-like nanoparticles NP. With this configuration, the photoelectric conversion device 1 according to this embodiment can improve the carrier transport efficiency.

The reflection suppression zone 142 is a layered region containing the string-like nanoparticles NP that are at least one of an insulator and a semiconductor. In other words, the reflection suppression zone 142 is a region in the photoactive layer 14 where the string-like nanoparticles NP are distributed.

As shown in Fig. 1, the reflection suppression zone 142 according to this embodiment is formed of string-like nanoparticles NP that are distributed in a layer shape and a dense part formed of photoelectric conversion materials distributed so as to fill the gaps between string-like nanoparticles NP.

As shown in Fig. 1, the reflection suppression zone 142 according to this embodiment is positioned between the photoactive zone 141 and the first carrier transport layer 13.

In the reflection suppression zone 142, the light incident from the z-axis negative side of the reflection suppression zone 142 is scattered by the distributed string-like nanoparticles NP. As a result, the reflection suppression zone 142 according to this embodiment can suppress reflection of the incident light.

After the reflection suppression zone 142 suppresses reflection of the incident light, the amount of light supplied to the photoactive zone 141 increases. As a result, the photoelectric conversion device 1 according to this embodiment can improve the photoelectron conversion efficiency.

Fig. 2 is a bird's eye view showing the shape of the string-like nanoparticles according to the first embodiment.

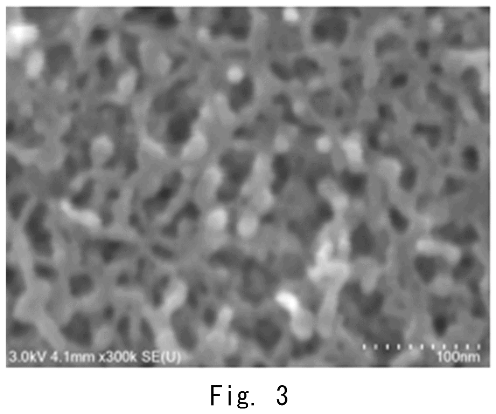

Further, Fig. 3 is a photograph showing a configuration of the string-like nanoparticles according to the first embodiment. More specifically, Fig. 3 is a photograph of string-like nanoparticles of silicon dioxide, which is a specific example of the string-like nanoparticles according to the first embodiment, captured using a scanning electron microscope.

As shown in Fig. 2, the string-like nanoparticles NP according to this embodiment are string-like nanoparticles having a substantially uniform diameter. The string-like nanoparticles NP may be curved-shaped nanoparticles as shown in Fig. 2 or may be linear-shaped nanoparticles. Note that the "string-like nanoparticles" may be referred to as, for example, "chain-like nanoparticles", "linear nanoparticles", or "rod-like nanoparticles".

From the viewpoint of suppressing the reflection of the incident light, the length corresponding to L1 in Fig. 2, that is, the length of the string-like nanoparticles NP in the longitudinal direction is preferably 200 nm or less, and particularly preferably 40 nm or more but 100 nm or less.

Further, from the viewpoint of suppressing the reflection of the incident light, the length corresponding to L2 in Fig. 2, that is, the length of the string-like nanoparticles NP in the radial direction is preferably 13 nm or more.

The string-like nanoparticles NP, which are at least one of an insulator and a semiconductor, may be, for example, metal oxide.

When the string-like nanoparticles NP are an insulator, the main component of the string-like nanoparticles NP may include, for example, silicon dioxide and aluminum nitride.

When the string-like nanoparticles NP are a semiconductor, the main component of the string-like nanoparticles NP may include, for example, zirconium oxide, yttrium oxide, silicon carbide, and titania.

When the main component of the string-like nanoparticles is an insulator, from the viewpoint of improving the photoelectron conversion efficiency, the thickness of the reflection suppression zone 142 is preferably 64 nm or less, and further preferably 37 nm or more but 64 nm or less.

From the viewpoint of improving the photoelectron conversion efficiency, the thickness of the reflection suppression zone 142 is preferably 0.10 times or less, further preferably 0.05 times or more but 0.10 times or less, and particularly preferably 0.056 times or more but 0.094 times or less of the thickness of the photoactive layer 14.

In other words, the thickness of the reflection suppression zone 142 is preferably 0.10 times or less, further preferably 0.05 times or more but 0.10 times or less, and particularly preferably 0.056 times or more but 0.094 times or less of a total thickness of the photoactive zone and the reflection suppression zone.

Note that the thickness of the reflection suppression zone here may be defined to be a thickness from the upper end to the lower end of the reflection suppression zone in the vertical cross section of the photoelectric conversion device.

The thickness of the reflection suppression zone can be measured, for example, by observation using a scanning electron microscope (SEM). In this case, the thickness of the reflection suppression zone may be measured as a distance from the upper end of the layer positioned in the lower part of the reflection suppression zone to the topmost end of the nanoparticles in the part where nanoparticles are deposited the most in a cross-sectional SEM image. Further, the thickness of the reflection suppression zone may be calculated as an average value of a plurality of values measured from cross-sectional SEM images captured in a plurality of fields of view, that is, a plurality of cross-sectional SEM images captured from different cross sections.

Further, the thickness of the photoactive zone may be defined to be a thickness from the upper end to the lower end of the photoactive zone in the vertical cross section of the photoelectric conversion device.

The thickness of the photoactive zone can be measured, for example, by observation using a scanning electron microscope (SEM). In this case, the thickness of the photoactive zone may be measured as a distance from the lower end of the layer positioned in the upper part of the photoactive zone to the topmost end of the string-like nanoparticles of the part where the string-like nanoparticles are deposited the most in a cross-sectional SEM image. Further, the thickness of the photoactive zone may be calculated as an average value of a plurality of values measured from cross-sectional SEM images captured in a plurality of fields of view, that is, a plurality of cross-sectional SEM images captured from different cross sections.

Further, the thickness of the photoactive layer herein may be defined to be a thickness from the upper end of the reflection suppression zone or the photoactive zone in the vertical cross section of the photoelectric conversion device to the lower end of the reflection suppression zone or the photoactive zone.

The thickness of the photoactive layer can be measured, for example, by observation using a scanning electron microscope (SEM). In this case, the thickness of the photoactive zone may be measured as a distance from the topmost end of the reflection suppression zone or the photoactive zone to the lowermost end of the reflection suppression zone or the photoactive zone in the cross-sectional SEM.

Further, the thickness of the photoactive layer may be calculated as an average value of a plurality of values measured from cross-sectional SEM images captured in a plurality of fields of view, that is, a plurality of cross-sectional SEM images captured from different cross sections.

Further, the thickness of the photoactive zone may be calculated as a sum of the respective measurement results of the thickness of the reflection suppression zone and the thickness of the photoactive zone.

While the reflection suppression zone 142 according to the present disclosure is formed as a part of the photoactive layer 14, the configuration of the reflection suppression zone 142 according to the present disclosure is not limited to this.

For example, in the photoelectric conversion device according to the present disclosure, string-like nanoparticles may be distributed inside the first electrode layer. In this case, the photoactive layer is a uniform layer that does not include string-like nanoparticles. Further, in this case, the entire region of the photoactive layer may be called a photoactive zone, or the region inside the first electrode layer where the string-like nanoparticles are distributed may be called a reflection suppression zone.

Further, in the photoelectric conversion device according to the present disclosure, the reflection suppression zone may be distributed inside the photoactive zone. That is, there may be a photoactive zone where there are no string-like nanoparticles in both of the upper part and the lower part of the region where the string-like nanoparticles are distributed.

Further, in the photoelectric conversion device according to the present disclosure, string-like nanoparticles may be distributed inside different layers positioned between the photoactive layer and the first electrode layer. In this case, the photoactive layer 14 according to the present disclosure is formed as a uniform layer that does not include string-like nanoparticles, and the total area may be called a photoactive zone. Further, in this case, the region where the string-like nanoparticles are distributed may be called a reflection suppression zone.

That is, the reflection suppression zone according to the present disclosure may have any configuration as long as it is positioned between the photoactive zone and the first electrode layer and includes string-like nanoparticles.

Further, the expression "the photoelectric conversion device includes a reflection suppression layer between the photoactive zone and the first electrode layer" in the present disclosure may include a case in which the photoelectric conversion device includes a reflection suppression zone inside the photoactive zone or the first electrode layer.

That is, the expression "the photoelectric conversion device includes a reflection suppression layer between the photoactive zone and the first electrode layer" in the present disclosure may indicate a case in which the photoelectric conversion device includes one or more dense layers made of a transparent conductive material, one or more dense layers made of a photoelectric conversion material, and includes a reflection suppression layer between these dense layers.

### (Configuration of Second Carrier Transport Layer 15)

As described above, the second carrier transport layer 15 according to this embodiment is an electron transport layer (ETL). The second carrier transport layer 15 is in contact with the photoactive layer 14 on the main surface on the z-axis negative side of the second carrier transport layer 15, and is in contact with the second electrode layer 16 on the main surface on the z-axis positive side of the second carrier transport layer 15. That is, the second carrier transport layer 15 according to this embodiment is positioned between the photoactive layer 14 and the second electrode layer 16.

The second carrier transport layer 15 transports conduction electrons generated in the photoactive layer 14 to the second electrode layer 16. In other words, the conduction electrons generated in the photoactive layer 14 are transported to the second electrode layer 16 via the second carrier transport layer 15.

Examples of the compound that can be used as a main component of the second carrier transport layer 15 include single-electron transport materials, oxide electron transport materials, sulfide electron transport materials, and organic electron transport materials.

Specific examples of the single-electron transport materials may include, for example, silicon or germanium. Specific examples of the oxide electron transport materials may include, for example, oxides of titanium, tin, zinc, iron, tungsten, zirconium, hafnium, strontium, indium, cerium, yttrium, lanthanum, vanadium, niobium, and tantalum. Specific examples of the sulfide electron transport materials may include, for example, sulfides of cadmium, zinc, lead, silver, antimony, and bismuth. Specific examples of the organic electron transport materials may include, for example, fullerene derivatives such as fullerene C₆₀ or phenyl-C₆₁-butyric acid methyl ester (PCBM, [6,6]-phenyl-C₆₁-butyric acid methyl ester).

### (Configuration of Second Electrode Layer 16)

The second electrode layer 16 is a conductive layer. The second electrode layer 16 is in contact with the second carrier transport layer 15 on the main surface on the z-axis negative side of the second electrode layer 16.

The second electrode layer 16 receives carriers generated in the photoactive layer 14 via the second carrier transport layer 15, and outputs the received carriers to the outside.

When the aforementioned second carrier transport layer 15 is an electron transport layer, the second electrode layer 16 receives conduction electrons generated in the photoactive layer 14 as carriers and outputs the received conduction electrons to the outside.

Further, when the second carrier transport layer 15 is a hole transport layer, the second electrode layer 16 receives the holes generated in the photoactive layer 14 as carriers and outputs the received holes to the outside.

The second electrode layer 16 may be an electrode layer having light transmission properties, or may be an electrode layer that does not have light transmission properties. That is, the second electrode layer 16 may be a transparent electrode layer or may not be a transparent electrode layer. In other words, the photoelectric conversion device 1 according to this embodiment may be a transparent photoelectric conversion device or may be a non-transparent photoelectric conversion device.

As described above, the photoelectric conversion device 1 according to this embodiment achieves special effects when it is used as an upper cell of a tandem solar cell or when it is used as a photoelectric conversion device of a solar cell used as a window glass. In these cases, the photoelectric conversion device 1 is transparent. That is, in the above cases, the second electrode layer 16 is implemented as a transparent electrode layer.

When the second electrode layer 16 is a transparent electrode layer, the material of the second electrode layer 16 may include, for example, Indium Tin Oxide (ITO), Indium Zinc Oxide (IZO), impurity-doped Zinc Oxide (ZnO), F-doped Tin Oxide (FTO), Antimony-doped Tin Oxide (ATO), graphene, and metal nanowires.

Note that the first electrode layer 12 and the second electrode layer 16 may be made of the same material or may be made of materials different from each other.

When the second electrode layer 16 is not a transparent electrode layer, examples of the material of the second electrode layer 16 may include, for example, metal such as gold, silver, copper, aluminum, tungsten, titanium, chromium, nickel, and cobalt.

As described above, the photoelectric conversion device 1 according to this embodiment includes a first electrode layer 12, which is a transparent electrode layer, a second electrode layer 16, and a photoactive zone 141 that is positioned between the first electrode layer 12 and the second electrode layer 16. The photoelectric conversion device 1 according to this embodiment further includes a reflection suppression zone 142 including string-like nanoparticles NP between the photoactive zone and the first electrode layer 12.

With the aforementioned configuration, light that is made incident on the photoelectric conversion device 1 is scattered by the string-like nanoparticles NP included in the reflection suppression zone 142, and reflection of the incident light is suppressed. As a result, the photoelectric conversion device 1 according to this embodiment can improve the photoelectron conversion efficiency.

### (Method for manufacturing Photoelectric conversion device)

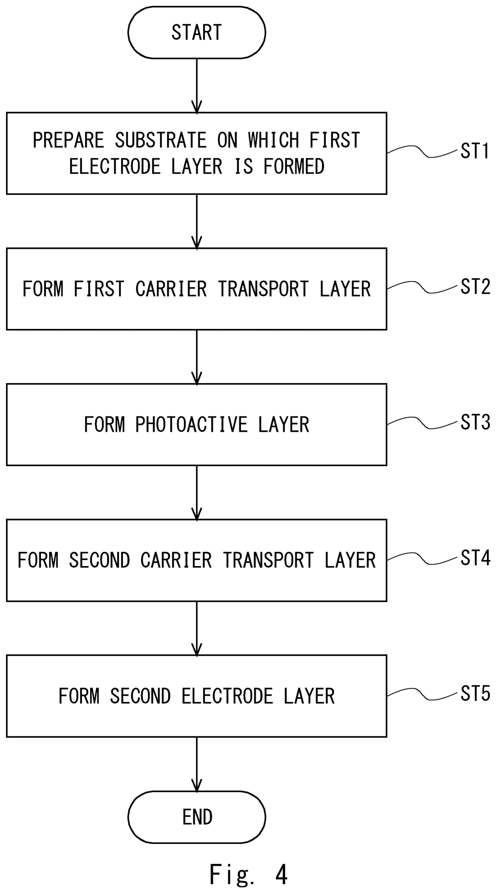

Next, a method for manufacturing a photoelectric conversion device according to this embodiment will be described in detail. Fig. 4 is a flowchart showing the method for manufacturing the photoelectric conversion device according to the first embodiment.

In the method for manufacturing the photoelectric conversion device according to this embodiment, first, a substrate 11 on which a first electrode layer 12 is formed is prepared (Step ST1).

Note that Step ST1 may be a process of forming the first electrode layer 12 on the substrate 11, or may be a process of preparing a commercially-available transparent electrode substrate.

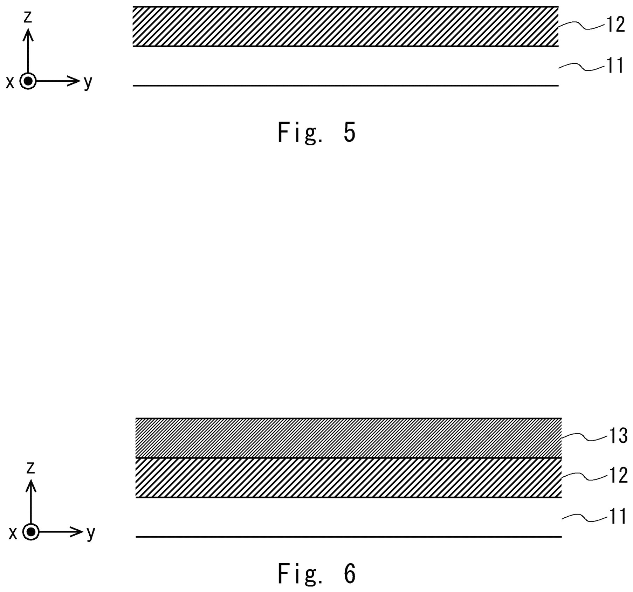

Fig. 5 is a schematic cross-sectional view for describing the method for manufacturing the photoelectric conversion device according to the first embodiment. More specifically, Fig. 5 is a schematic cross-sectional view showing a configuration of the photoelectric conversion device 1 after Step ST1 is completed but before Step ST2 is performed.

As shown in Fig. 5, in the photoelectric conversion device 1 after Step ST1 is completed, the first electrode layer 12 is formed on the substrate 11.

In the method for manufacturing the photoelectric conversion device according to this embodiment, next, a first carrier transport layer 13 is formed (Step ST2). More specifically, in Step ST2, the first carrier transport layer 13 is formed on the first electrode layer 12.

The method for forming the first carrier transport layer 13 may include a method in which a solution in which the material of the first carrier transport layer 13 is dissolved is applied and then a solvent is volatilized, a method for vacuum-depositing the material of the first carrier transport layer 13, or the like. The method for forming the first carrier transport layer 13 can be selected as appropriate depending on the material of the first carrier transport layer 13.

Note that the method for applying the solution may include, for example, an inkjet method, a spray coating method, a die coating method, and a spin coating method.

Fig. 6 is a schematic cross-sectional view for describing the method for manufacturing the photoelectric conversion device according to the first embodiment. More specifically, Fig. 6 is a schematic cross-sectional view showing a configuration of the photoelectric conversion device 1 after Step ST2 is completed but before Step ST3 is performed.

As shown in Fig. 6, in the photoelectric conversion device 1 after ST2 is completed, the first carrier transport layer 13 is formed on the first electrode layer 12.

In the method for manufacturing the photoelectric conversion device according to this embodiment, next, a photoactive layer 14 is formed (Step ST3). More specifically, in Step ST3, the photoactive layer 14 is formed on the first carrier transport layer 13. Note that, as described above, the photoactive layer 14 according to this embodiment includes the photoactive zone 141 and the reflection suppression zone 142.

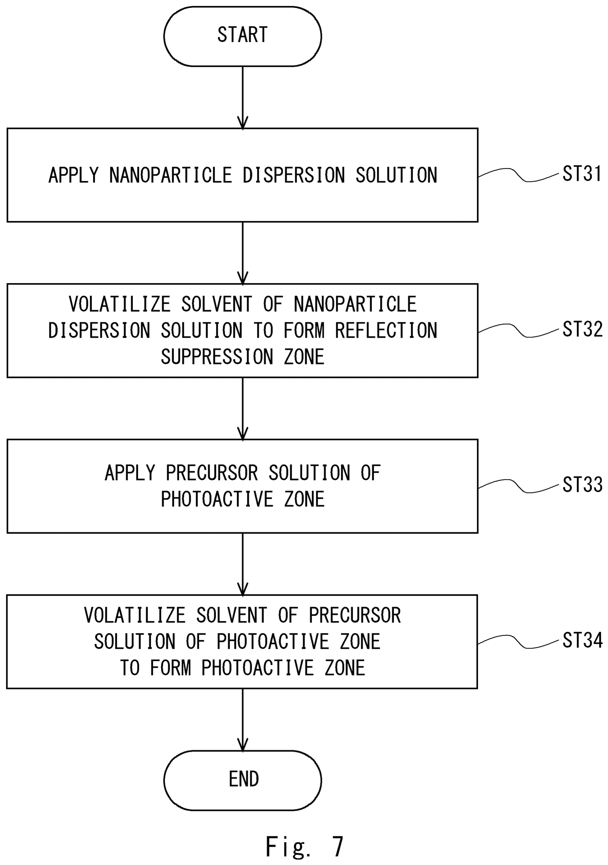

Fig. 7 is a flowchart showing the method for manufacturing the photoelectric conversion device according to the first embodiment. More specifically, Fig. 7 is a flowchart showing the process of Step ST3 in Fig. 4 in more detail.

In Step ST5, first, a nanoparticle dispersion solution is applied (Step ST31). More specifically, in Step ST31, a nanoparticle dispersion solution is applied onto the first carrier transport layer 13.

Note that the method for applying the solution may include, for example, an inkjet method, a spray coating method, a die coating method, and a spin coating method.

Note that the concentration of the nanoparticle dispersion solution to be applied can be set as appropriate depending on the type of nanoparticles to be used or performance desired for the photoelectric conversion device 1.

From the viewpoint of suppressing reflection of the incident light, the concentration of the nanoparticle dispersion solution is preferably 3.0 wt% or less, further preferably 0.5% or more but 2.5 wt% or less, and particularly preferably 1.0% or more but 2.0 wt% or less.

Further, from the viewpoint of improving the photoelectron conversion efficiency, the concentration of the nanoparticle dispersion solution is particularly preferably 0.5% or more but 1.0 wt% or less.

In Step ST3, next, the solvent of the nanoparticle dispersion solution is volatilized. (Step ST32).

As a result of execution of Step ST32, the string-like nanoparticles NP dispersed in the solution are deposited on the first carrier transport layer 13.

While the details will be described later, a dense part of the photoelectric conversion material is formed in gaps between the deposited string-like nanoparticles NP, whereby the reflection suppression zone 142 is formed.

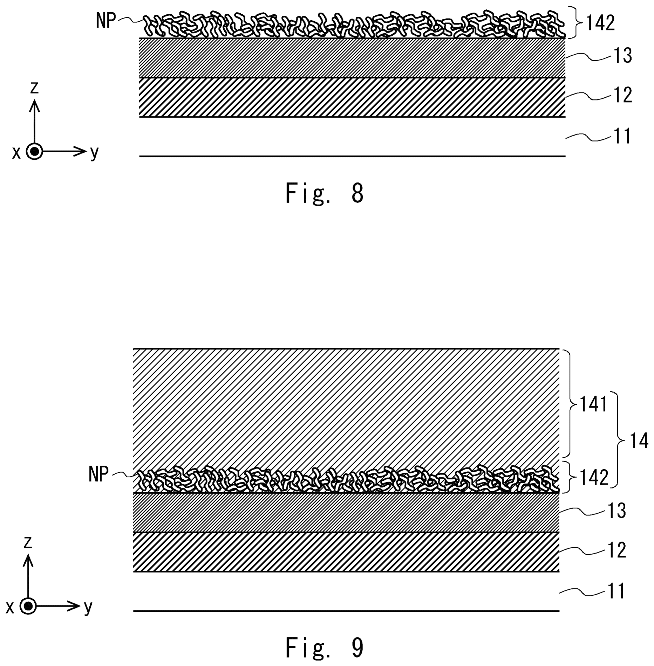

Fig. 8 is a schematic cross-sectional view for describing the method for manufacturing the photoelectric conversion device according to the first embodiment. More specifically, Fig. 8 is a schematic cross-sectional view showing a configuration of the photoelectric conversion device 1 after Step ST32 is completed but before Step ST33 is performed.

As shown in Fig. 8, in the photoelectric conversion device 1 after Step ST32 is completed, string-like nanoparticles NP are deposited on the first carrier transport layer 13.

It can be said, in the photoelectric conversion device 1 after Step ST32 is completed, that the string-like nanoparticles NP are uniformly distributed on the first carrier transport layer 13, or a nanoparticle layer is formed.

In Step ST3, next, a precursor solution of the photoactive zone 141 is applied (Step ST33). More specifically, in Step ST33, the precursor solution of the photoactive zone 141 is applied onto the first carrier transport layer 13 having a surface on which the string-like nanoparticles NP are deposited. Note that the precursor solution of the photoactive zone 141 is a solution including a photoelectric conversion material as a solute. In this embodiment, the precursor solution of the photoactive zone 141 is a solution including perovskite compounds as a solute.

As a result of execution of Step ST33, the precursor solution of the photoactive zone 141 permeates into the gaps between the deposited string-like nanoparticles NP. Further, as a result of execution of Step ST33, a liquid film of the precursor solution is formed in the upper part of the deposited string-like nanoparticles NP.

The method for applying the solution may include, for example, an inkjet method, a spray coating method, a die coating method, and a spin coating method.

In Step ST3, lastly, a solvent of the precursor solution of the photoactive zone 141 is volatilized. (Step ST34). As a result of execution of Step ST34, the formation of the photoactive layer 14, that is, Step ST3, is completed.

As a result of execution of Step ST34, the photoelectric conversion material precipitates so as to fill the gaps between the deposited string-like nanoparticles NP, whereby the reflection suppression zone 142 is formed. Further, as a result of execution of Step ST34, the photoelectric conversion material precipitates in the upper part of the reflection suppression zone 142, whereby the photoactive zone 141 is formed.

Fig. 9 is a schematic cross-sectional view for describing the method for manufacturing the photoelectric conversion device according to the first embodiment. More specifically, Fig. 9 is a schematic cross-sectional view showing a configuration of the photoelectric conversion device 1 after Step ST34 is completed but before Step ST4 is performed.

As shown in Fig. 9, in the photoelectric conversion device 1 after Step ST34 is completed, the photoactive zone 141 is formed on the reflection suppression zone 142.

Referring back to Fig. 4, the explanation will be continued.

In the method for manufacturing the photoelectric conversion device according to this embodiment, next, the second carrier transport layer 15 is formed (Step ST4). More specifically, in Step ST4, the second carrier transport layer 15 is formed on the photoactive layer 14.

Examples of the method for forming the second carrier transport layer 15 may include a method for volatilizing a solvent after applying a solution in which the material of the second carrier transport layer 15 is dissolved or a method for vacuum-depositing the material of the second carrier transport layer 15. The method for forming the second carrier transport layer 15 can be selected as appropriate depending on the material of the second carrier transport layer 15.

Note that the method for applying the solution may include, for example, an inkjet method, a spray coating method, a die coating method, a spin coating method, or the like.

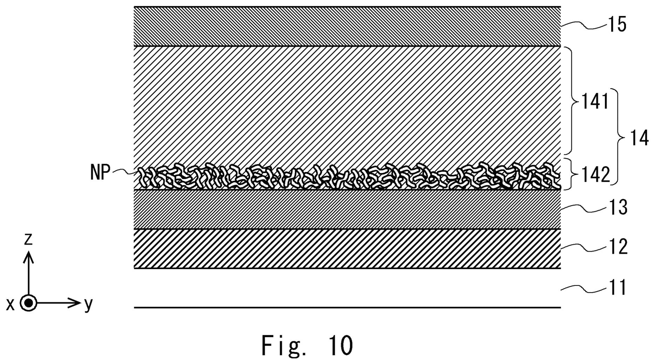

Fig. 10 is a schematic cross-sectional view for describing the method for manufacturing the photoelectric conversion device according to the first embodiment. More specifically, Fig. 10 is a schematic cross-sectional view showing a configuration of the photoelectric conversion device 1 after Step ST4 is completed but before Step ST5 is performed.

As shown in Fig. 10, in the photoelectric conversion device 1 after Step ST4 is completed, the second carrier transport layer 15 is formed on the photoactive layer 14.

In the method for manufacturing the photoelectric conversion device according to this embodiment, at last, a second electrode layer 16 is formed (Step ST5), whereby the photoelectric conversion device 1 is completed.

More specifically, in Step ST5, the second electrode layer 16 is formed on the second carrier transport layer 15. As a result of execution of Step ST5, the state of the photoelectric conversion device according to this embodiment is as shown in Fig. 1.

The method for forming the second electrode layer 16 may include, for example, a method for volatilizing a solvent after applying a solution in which the material of the second electrode layer 16 is dissolved or a method for vacuum-depositing the material of the second electrode layer 16. The method for forming the second electrode layer 16 can be selected as appropriate depending on the material of the second electrode layer 16.

Note that the method for applying a solution may include, for example, an inkjet method, a spray coating method, a die coating method, and a spin coating method.

As described above, the method for manufacturing the photoelectric conversion device according to this embodiment includes a process of applying a nanoparticle dispersion solution; a process of volatilizing a solvent of the nanoparticle dispersion solution; a process of applying a precursor solution of a photoactive zone; and a process of volatilizing a solvent of the precursor solution of the photoactive zone. According to this manufacturing method, the photoelectric conversion device according to the present disclosure can be manufactured.

### [Examples]

While the present disclosure will be described hereinafter in more detail using Examples, the present disclosure is not limited to these Examples.

### <Preparation of Photoelectric conversion device>

### (Examples)

3PATAT-C3 was dissolved in N,N-dimethylformamide (DMF) to prepare a precursor solution of a hole transport layer. The prepared precursor solution of the hole transport layer was applied onto an ITO glass substrate by spin coating. After that, the applied precursor solution of the hole transport layer was annealed at 110 degrees Celsius to form a hole transport layer.

Note that these processes correspond to Steps ST1 and ST2 in Fig. 4.

Next, string-like nanoparticles of silicon dioxide whose length in the longitudinal direction is 40 nm or more but 100 nm or less and average value of the length in the radial direction is 15.1 nm were dispersed into isopropyl alcohol at various concentrations to prepare nanoparticle dispersion solutions. The prepared nanoparticle dispersion solutions were applied onto the formed hole transport layer by spin coating. After that, the applied nanoparticle dispersion solutions were annealed at 110 degrees Celsius. Note that these processes correspond to Steps ST31 and ST32 in Fig. 7.

Note that the lengths of the string-like nanoparticles in the longitudinal direction and the lengths of the string-like nanoparticles in the radial direction are values measured by observation using a scanning electron microscope (SEM).

12 particles were randomly extracted from an image captured by the scanning electron microscope and the lengths of the string-like nanoparticles in the radial direction were measured, and then an average value and the standard deviation thereof were calculated. As described above, the average value was 15.1 nm and the standard deviation was 2.20. Further, the maximum value of the diameters of the nanoparticles that have been measured was 18.7 nm and the minimum value thereof was 12.4 nm.

Note that
Example 1 is an example in which the concentration of the nanoparticle dispersion solution is 0.5 wt%,
Example 2 is an example in which the concentration of the nanoparticle dispersion solution is 1.0 wt%,
Example 3 is an example in which the concentration of the nanoparticle dispersion solution is 1.5 wt%,
Example 4 is an example in which the concentration of the nanoparticle dispersion solution is 2.0 wt%, and
Example 5 is an example in which the concentration of the nanoparticle dispersion solution is 3.0 wt%.

Next, cesium iodide (CsI), methylammonium bromide (MABr), formamidinium iodide (FAI), lead iodide (PbI₂), and lead bromide (PbBr₂) were dissolved into a mixed solvent of N,N-dimethylformamide (DMF) and dimethyl sulfoxide (DMSO), and a precursor solution of the photoactive zone was prepared. The prepared precursor solution of the photoactive zone was applied onto the deposited nanoparticles by spin coating, and chlorobenzene was dropped to the applied precursor solution of the photoactive zone. After that, annealing was performed to form a photoactive zone and a reflection suppression zone. These processes correspond to Steps ST33 and ST34 in Fig. 7.

Next, [6,6]-phenyl-C₆₁-butyric acid methyl ester was dissolved into 2-propanol and a solution was prepared. The prepared solution was applied, by spin coating, onto a substrate on which a perovskite layer was formed, and then the solvent was dried to form an electron transport layer. Note that these processes correspond to Step ST4 in Fig. 4.

Last, silver was vacuum-deposited onto the formed electron transport layer and a second electrode layer was formed, whereby photoelectric conversion devices according to the Examples were prepared. This process corresponds to Step ST5 in Fig. 4.

### (Comparative Example 1)

A photoelectric conversion device was prepared like in Examples except that the reflection suppression zone was not formed.

### (Comparative Example 2)

A photoelectric conversion device was prepared like in Examples except that solutions in which spherical nanoparticles of silicon dioxide whose average particle diameter was 19.3 nm were dispersed into isopropyl alcohol at various concentrations were used as nanoparticle dispersion solutions.

Note that, like in Examples, the average particle diameter of the spherical nanoparticles of silicon dioxide is a value measured by observation using a scanning electron microscope (SEM).

12 particles were randomly extracted from an image captured by the scanning electron microscope, the diameters of the nanoparticles were measured, and the average value and the standard deviation thereof were calculated. As described above, the average value was 19.3 nm and the standard deviation was 3.87. Further, the maximum value of the diameters of the nanoparticles that have been measured was 27.0 nm, and the minimum value thereof was 11.9 nm.

### (Comparative Example 3)

A photoelectric conversion device was prepared like in Examples except that solutions in which nanoparticles of silicon diode whose average particle diameter was 115.5 nm were dispersed into isopropyl alcohol at various concentrations were used as nanoparticle dispersion solutions.

Note that, like in Examples, the average particle diameter of the nanoparticles is a value measured by observation using a scanning electron microscope (SEM).

12 particles were randomly extracted from an image captured by the scanning electron microscope, the diameters of the nanoparticles were measured, and the average value and the standard deviation thereof were calculated. As described above, the average value was 115.5 nm and the standard deviation was 6.35. Further, the maximum value of the diameters of the nanoparticles that have been measured was 125.3 nm, and the minimum value thereof was 103.2 nm.

### <Estimation of Magnitude of Short-circuit Current Density lost due to Light Reflection>

### (Estimation Method)

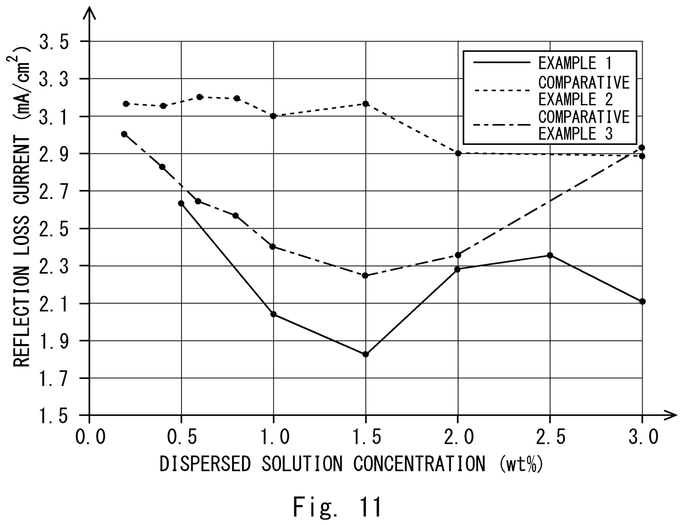

By using an air mass (AM) 1.5 G solar simulator, the prepared photoelectric conversion devices were irradiated with light, and light reflectance was measured. The magnitude of the short-circuit current density lost due to light reflection was estimated based on the measured light reflectance. Fig. 11 shows the estimation results.

Fig. 11 is a graph showing results of estimating the short-circuit current density lost as a result of light reflection. More specifically, Fig. 11 is a graph in which results of estimating the short-circuit current density that is lost in the photoelectric conversion device according to Example 1 and results of estimating the short-circuit current density that is lost in the photoelectric conversion devices according to Comparative Example 2 and Comparative Example 3 are plotted with respect to the dispersed solution concentration.

### (Study of Estimation Results)

It has been found, from the results shown in Fig. 11, that since the photoelectric conversion device according to this Example includes a reflection suppression zone including string-like nanoparticles, the loss of the short-circuit current density due to light reflection can be further suppressed compared to those in the photoelectric conversion devices having the reflection suppression zone including spherical nanoparticles.

Further, it has been found, from the results shown in Fig. 11, that, from the viewpoint of suppressing the loss of the short-circuit current density due to light reflection, that the concentration of the string-like nanoparticle dispersion solution was preferably 3.0 wt% or less, further preferably 0.5% or more but 2.5 wt% or less, and particularly preferably 1.0% or more but 2.0 wt% or less.

### <Measurement of Thickness of Reflection suppression zone in Photoelectric conversion device>

### (Measurement Method)

For each of some of Examples, the cross section of the prepared photoelectric conversion device was observed by a scanning electron microscope (SEM), and the thickness of the reflection suppression zone and the thickness of the photoactive layer were measured. Table 1 shows the results.

More specifically, cross-sectional SEM images were captured for three fields of views. The captured cross-sectional SEM images of the photoelectric conversion device were observed, and the distance from the upper end of the layer positioned in the lower part of the reflection suppression zone to the topmost end of the nanoparticles of the part where the nanoparticles are deposited the most was measured. Then the average value of the distances measured for each field of view was calculated as the thickness of the reflection suppression zone.

Further, the distance from the upper end to the lower end of the photoactive layer was measured, the captured cross-sectional SEM images of the photoelectric conversion device were observed, and the distance from the upper end to the lower end of the photoactive layer was measured. Then, the average value of the distances measured for each field of view was calculated as the thickness of the photoactive layer.

Note that, in the measurement, 3-5 photoelectric conversion devices were prepared for each of the Examples and each of the comparative examples, and the average value thereof was calculated.

### <Battery Performance Evaluation of Photoelectric conversion device>

### (Measurement Method)

For each of some of Examples, the prepared photoelectric conversion device was irradiated with light by using an air mass (AM) 1.5 G solar simulator, and an open-circuit voltage and photoelectron conversion efficiency were measured. Table 1 shows the results. Note that, in the measurement, 3-5 photoelectric conversion devices were prepared for each of the Examples and each of the comparative examples, and its average value was calculated.

**[Table 1]**

| Example | Application concentration (wt%) | Thickness | | | | | | Open-circuit voltage | Photoelectric conversion efficiency |
|---|---|---|---|---|---|---|---|---|---|
| | | Reflection suppression zone | | Photoactive layer | | Reflection suppression zone/Photoactive layer | | | |
| | | Measured value (nm) | Average value (nm) | Measured value (nm) | Average value (nm) | Measured value | Average value | Average value Rate to Comparative Example 1 | Average value Rate to Comparative Example 1 |
| Example 1 | 0.5 | 38.0 | 37.0 | 604.5 | 652.7 | 0.0629 | 0.0568 | 1.036 | 1.086 |
| | | 37.5 | | 660.5 | | 0.0568 | | | |
| | | 33.0 | | 653.0 | | 0.0505 | | | |
| | | 44.0 | | 675.0 | | 0.0652 | | | |
| | | 32.5 | | 670.5 | | 0.0485 | | | |
| Example 2 | 1.0 | 65.0 | 63.9 | 677.5 | 681.4 | 0.0959 | 0.0937 | 1.028 | 1.043 |
| | | 67.5 | | 681.5 | | 0.0990 | | | |
| | | 62.5 | | 678.0 | | 0.0922 | | | |
| | | 53.0 | | 678.5 | | 0.0781 | | | |
| | | 71.5 | | 691.5 | | 0.1034 | | | |
| Example 3 | 1.5 | 93.0 | 91.3 | 668.5 | 676.4 | 0.1391 | 0.1351 | 1.035 | 0.932 |
| | | 92.0 | | 655.0 | | 0.1405 | | | |
| | | 93.0 | | 680.0 | | 0.1368 | | | |
| | | 88.0 | | 706.0 | | 0.1246 | | | |
| | | 90.5 | | 672.5 | | 0.1346 | | | |
| Example 4 | 2.0 | 126.0 | 123.2 | 697.5 | 707.5 | 0.1806 | 0.1742 | 1.036 | 0.949 |
| | | 121.5 | | 716.5 | | 0.1696 | | | |
| | | 122.0 | | 707.0 | | 0.1726 | | | |
| | | 122.0 | | 702.0 | | 0.1738 | | | |
| | | 124.5 | | 714.5 | | 0.1742 | | | |
| Example 5 | 3.0 | 148.5 | 157.7 | 764.0 | 728.0 | 0.1944 | 0.2170 | 1.044 | 0.876 |
| | | 154.0 | | 691.5 | | 0.2227 | | | |
| | | 155.5 | | 747.5 | | 0.2080 | | | |
| | | 163.0 | | 704.5 | | 0.2314 | | | |
| | | 167.5 | | 732.5 | | 0.2287 | | | |

### (Study of Table 1)

It has been found, from the results shown in Table 1, that, since the photoelectric conversion devices according to the Examples include the reflection suppression zone, the photoelectron conversion efficiency and the open-circuit voltage can be improved.

From the viewpoint of improving the photoelectron conversion efficiency, it has been found, from the comparison between Examples 1 and 2 and Examples 3, 4, and 5, that the thickness of the reflection suppression zone is preferably 37 nm or more but 64 nm or less.

Further, from the viewpoint of improving the photoelectron conversion efficiency, it has been found, from the comparison between Examples 1 and 2 and Examples 3, 4, and 5, that the thickness of the reflection suppression zone is preferably 0.10 times or less, further preferably 0.05 times or more but 0.10 times or less, and particularly preferably 0.056 times or more but 0.094 times or less of the thickness of the photoactive layer.

While the present disclosure has been described in view of the aforementioned embodiment, the present disclosure is not limited to the configurations of the above embodiment. As a matter of course, the present disclosure includes various variations, modifications, and combinations that may be made by one skilled in the art within the scope of the disclosure set forth in the claims of the present application.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A photoelectric conversion device comprising a first electrode layer (12), which is a transparent electrode, a second electrode layer (16), and a photoactive zone (141) that is positioned between the first electrode layer (12) and the second electrode layer (16), the photoelectric conversion device further comprising:
a reflection suppression zone (142) including string-like nanoparticles between the photoactive zone (141) and the first electrode layer (12).

2. The photoelectric conversion device according to claim 1, further comprising a carrier transport layer provided between the first electrode layer (12) and the photoactive zone (141),
wherein the reflection suppression zone (142) is positioned between the photoactive zone (141) and the carrier transport layer.

3. The photoelectric conversion device according to claim 1 or 2, wherein the string-like nanoparticles include silicon dioxide as a main component.

4. The photoelectric conversion device according to claim 1 or 2, wherein a thickness of the reflection suppression zone (142) is 37 nm or more but 64 nm or less.

5. The photoelectric conversion device according to claim 1 or 2, wherein a thickness of the reflection suppression zone (142) is 0.10 times or less of a total of a thickness of the photoactive zone (141) and a thickness of the reflection suppression zone (142).

6. The photoelectric conversion device according to claim 5, wherein the thickness of the reflection suppression zone (142) is 0.05 times or more but 0.10 times or less of a total of the thickness of the photoactive zone (141) and the thickness of the reflection suppression zone (142).

7. The photoelectric conversion device according to claim 1 or 2, wherein a length of the string-like nanoparticles in a longitudinal direction is 40 nm or more but 100 nm or less.

8. The photoelectric conversion device according to claim 1 or 2, wherein a length of the string-like nanoparticles in a radial direction is 13 nm or more.

9. The photoelectric conversion device according to claim 1 or 2, wherein the photoactive zone (141) contains a perovskite compound as a main component.

10. The photoelectric conversion device according to claim 2, wherein there is a region where the photoactive zone (141) and the carrier transport layer contact each other without the string-like nanoparticles interposed therebetween.

11. A method for manufacturing a photoelectric conversion device comprising a first electrode layer (12), which is a transparent electrode, a second electrode layer (16), and a photoactive zone (141) that is positioned between the first electrode layer (12) and the second electrode layer (16), the method comprising:
preparing a substrate that includes a first electrode layer (12);
forming a reflection suppression zone (142) including string-like nanoparticles; and
forming a photoactive zone (141).

12. The method for manufacturing the photoelectric conversion device according to claim 11, further comprising forming a carrier transport layer on the first electrode layer (12), wherein
forming the reflection suppression zone (142) comprises:
applying a nanoparticle dispersion solution onto the carrier transport layer; and
volatilizing a solvent of the nanoparticle dispersion solution, and forming the photoactive zone (141) comprises:
applying the precursor solution of a photoactive zone (141) on the reflection suppression zone (142); and
volatilizing the solvent of the precursor solution of the photoactive zone (141).

13. The method for manufacturing the photoelectric conversion device according to claim 12, wherein a concentration of the string-like nanoparticles of the nanoparticle dispersion solution is 3.0 wt% or less.

14. The method for manufacturing the photoelectric conversion device according to claim 13, wherein a concentration of the string-like nanoparticles of the nanoparticle dispersion solution is 0.5% or more but 2.5 wt% or less.

15. The method for manufacturing the photoelectric conversion device according to claim 14, wherein a concentration of the string-like nanoparticles of the nanoparticle dispersion solution is 1.0% or more but 2.0 wt% or less.
